# DEMANDE DE BREVET EUROPEEN

(11) **EP 0 672 912 A1**
(43) Date de publication de la demande: **20.09.1995**
(21) Numéro de dépôt: 95810127.1
(22) Date de dépôt: 28.02.1995
(51) Int. Cl.: G01R 31/34

(54) **Dispositif indicateur de l'état d'un moteur asynchrone monophasé**

(30) Priorité: 16.03.1994 FR 9403096
(71) Demandeur: SOMFY, F-74300 Cluses (FR)
(72) Inventeur: Orsat, Jean-Michel, F-74300 Chatillon/Cluses (FR); Utsumi, Yutaka, Hiratsuka City, Kanagawa 254 (JP)
(74) Mandataire: Meylan, Robert Maurice

(57) **Abrégé**

Dispositif indicateur de l'état d'un moteur asynchrone monophasé (MO) à condensateur de déphasage, comportant un interrupteur d'arrêt automatique (FC1, FC2) sur chaque conducteur de phase et un interrupteur thermique (TH) sur le conducteur de retour et dont le sens de rotation peut être inversé au moyen d'un commutateur (CM). Le dispositif indicateur est constitué d'un détecteur de courant (DC), d'un détecteur de tension (DT) et d'une logique de traitement (LT) délivrant respectivement une information sur le sens de rotation du moteur, l'état des interrupteurs de conducteurs de phase et de l'interrupteur thermique.

## Description

La présente invention a pour objet un dispositif indicateur de l'état d'un moteur asynchrone monophasé à condensateur de déphasage comportant un interrupteur d'arrêt automatique sur chaque conducteur de phase et un interrupteur thermique sur le conducteur de retour et dont le sens de rotation peut être inversé au moyen d'un commutateur permettant d'appliquer la tension d'alimentation sur l'une ou l'autre des bornes du condensateur de déphasage, de telle sorte que l'un ou l'autre des enroulements du moteur travaille en phase principale.

Les moteurs concernés sont notamment les moteurs utilisés pour entraîner des stores, des volets roulants ou des portes. Les interrupteurs d'arrêt font partie de dispositifs de mesure de déplacement de l'objet entraîné qui mesurent ce déplacement en comptant le nombre de tours du moteur. De tels dispositifs sont décrits notamment dans les brevets FR 2 455 695 et 2 688 022 et dans le brevet EP 0 524 152. Le commutateur permet soit d'interrompre l'alimentation sur les deux conducteurs de phase, soit d'alimenter l'un ou l'autre de ces conducteurs pour faire tourner le moteur dans un sens ou dans l'autre. Dans leur utilisation habituelle, les interrupteurs déterminent les points d'ouverture et de fermeture maximum de l'objet entraîné.

Un tel moteur peut se trouver dans divers états, à savoir ceux dans lesquels le moteur tourne dans un sens ou dans l'autre, car le commutateur, au point de commande, alimente l'un ou l'autre des conducteurs de phase, et ceux dans lesquels le moteur est arrêté, car l'un ou l'autre des interrupteurs d'arrêt automatique ou l'interrupteur thermique est ouvert. Dans certains cas d'utilisation, il est utile, voire nécessaire, de connaître la situation du moteur. Ce peut être, par exemple, le besoin de surveillance ou le besoin de déclencher de façon synchronisée des séquences d'automatisme.

Pour déterminer de façon complète l'état du moteur, il est nécessaire de connaître l'état des interrupteurs de conducteurs de phase, l'état de l'interrupteur thermique, ainsi que l'état du commutateur de sens, car le moteur peut être arrêté pour la simple raison que le commutateur est au point milieu.

Il est connu, par exemple du document GB-A-2 168 497, de mesurer la charge d'un moteur à induction par la mesure du déphasage entre le courant et la tension, mais cette mesure ne permet toutefois pas de connaître le sens de rotation du moteur, ni l'état des conducteurs de phase et de l'interrupteur thermique.

Pour résoudre ce problème, il a été proposé de connecter, en certains points du moteur, des conducteurs témoins que l'on fait sortir avec les autres conducteurs. Ces conducteurs témoins sont reliés à travers des relais au conducteur de retour, les contacts de ces relais alimentant des récepteurs. Deux relais sont branchés directement sur les conducteurs de phase partant des bornes du commutateur pour le signalement de la présence d'une tension d'alimentation sur l'une ou l'autre des bornes du commutateur. Deux autres relais sont alimentés lors de l'ouverture des interrupteurs des conducteurs de phase et un cinquième relais est monté en parallèle à l'interrupteur thermique. Cette solution présente plusieurs inconvénients. Tout d'abord, les interrupteurs de fin de course doivent être remplacés par des inverseurs, ce qui implique une modification et une complication des équipements standard. D'autre part, les moteurs nécessitent une fabrication spéciale plus coûteuse, du fait des éléments rajoutés et de la gestion particulière qu'ils génèrent. Enfin, la présence sur le boîtier du moteur de trois conducteurs de sortie supplémentaires a un l'effet perturbateur et elle est source d'erreur lors du branchement du moteur par l'installateur.

L'invention a pour but de réaliser un dispositif indicateur obviant aux inconvénients susmentionnés, c'est-à-dire un indicateur n'exigeant aucune modification du moteur, ni intervention dans ce dernier, de telle sorte qu'il peut être utilisé avec un moteur standard.

Le dispositif indicateur selon l'invention est caractérisé en ce qu'il comprend deux détecteurs de courant détectant respectivement la présence de courant dans chacun des conducteurs de phase et présentant chacun une sortie susceptible de prendre deux états distincts, deux détecteurs de tension détectant respectivement la présence d'une tension sur chacune des bornes du commutateur reliées aux conducteurs de phase et présentant chacun une sortie susceptible de prendre deux états distincts, et une logique de traitement aux entrées de laquelle sont appliqués les états des détecteurs de courant et des détecteurs de tension, cette logique de traitement étant agencée de manière à analyser les différentes combinaisons des états des entrées et à délivrer, sur cinq sorties, des signaux représentatifs de l'état des interrupteurs d'arrêt automatique, de l'interrupteur thermique et du sens de rotation du moteur.

Les détecteurs de courant sont réalisés de préférence au moyen d'ampoules Reed, en raison de leur coût très bas et de leur commodité d'utilisation. Quelques spires du conducteur enroulées autour de l'ampoule suffisent à fermer son contact. Les détecteurs de courant et de tension et la logique de traitement sont avantageusement montés dans un boîtier unique indépendant qui constitue un accessoire autonome qu'il est aisé d'intercaler entre le point de commande comportant le commutateur de sens et un moteur standard, en un point quelconque, qu'il s'agisse d'un moteur déjà installé, en cas de rénovation, ou non. Dans le cas où les détecteurs de courant, ainsi que les dispositifs d'affichage de l'état des sorties de la logique de traitement ont besoin d'une alimentation en courant continu, cette alimentation en courant continu peut être fournie par les détecteurs de tension.

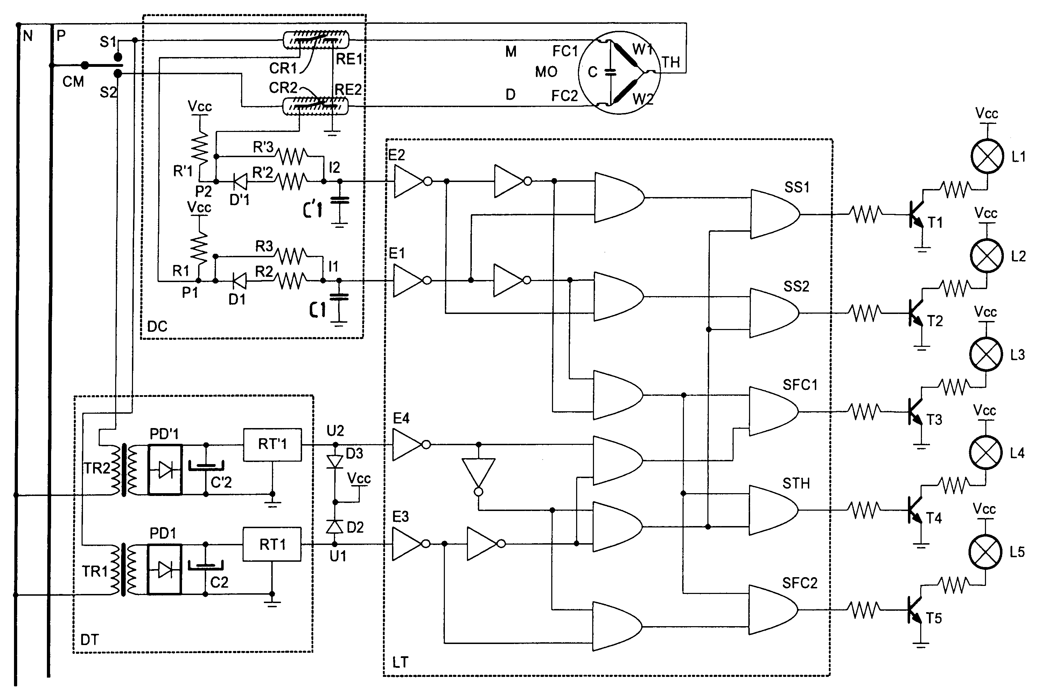

Le dessin annexé représente, à titre d'exemple, un mode d'exécution de l'invention.

L'unique figure du dessin représente le schéma de l'installation comprenant le moteur et le dispositif indicateur de l'état du moteur.

Dans le schéma représenté, on reconnaît un moteur asynchrone monophasé MO comprenant deux enroulements de phase W1 et W2 et un condensateur de déphasage C. Dans le boîtier du moteur symbolisé par un cercle, on trouve en outre deux interrupteurs de fin de course FC1 et FC2, fermés au repos sur les conducteurs de phase M et D, les conducteurs M et D, étant respectivement considérés comme les conducteurs de "Montée" et "Descente" dans le cas d'une application à l'entraînement d'un volet roulant. Les dispositifs de comptage du nombre de tours du moteur et d'actionnement des interrupteurs de fin de course FC1 et FC2 sont considérés comme intégrés au moteur. Le moteur est en outre équipé d'un interrupteur thermique TH sur le conducteur de retour relié directement au neutre N du secteur dont la phase P est reliée au contact d'un commutateur CM placé au point de commande du moteur. Le commutateur CM comprend deux bornes S1 et S2 auxquelles peut être relié le contact du commutateur représenté en position médiane. La borne S1 est reliée au conducteur de phase M, tandis que la borne S2 est reliée au conducteur de phase D. Si la tension d'alimentation est appliquée au conducteur M, l'enroulement W1 travaille en phase principale et l'enroulement W2 travaille en phase auxiliaire et le moteur tourne dans un premier sens. Si c'est le conducteur D qui est alimenté, l'enroulement W2 travaille en phase principale et l'enroulement W1 en phase auxiliaire et le moteur tourne dans l'autre sens.

Le conducteur M est enroulé par quelques spires autour d'une première ampoule Reed RE1 abritant un contact CR1, tandis que le conducteur D est enroulé de la même manière autour d'une seconde ampoule Reed R2 abritant un contact CR2. L'une des bornes du contact CR1 est reliée à la terre et l'autre borne est reliée, d'une part, à une source de courant continu Vcc à travers une résistance R1 et, d'autre part, à la terre, en parallèle avec le contact CR1, à travers une diode D1, une résistance R2 et un condensateur C1, une troisième résistance R3 étant branché en parallèle à la diode D1 et à la résistance R2. La cathode de la diode D1 est reliée à la borne P1 de la résistance R1 reliée au contact Reed CR1.

De manière analogue, le contact CR2 de la seconde ampoule Reed est relié à un circuit identique composé des résistances R'1, R'2 et R'3, d'une diode D'1 et d'un condensateur C'1.

Chacun de ces circuits constitue un détecteur de courant DC sur le conducteur de phase correspondant. On se contentera de décrire le fonctionnement du détecteur de courant dans le conducteur de phase M.

En l'absence de courant, dans le conducteur M, le contact de Reed CR1 est ouvert. La diode D1 est bloquée et le condensateur C1 se charge à la tension continue positive Vcc à travers les résistances R1 et R3. Le point I1, c'est-à-dire la borne du condensateur C1 relié aux résistances, prend un premier niveau de tension désigné niveau haut H. Si un courant traverse le conducteur M, le contact CR1 se ferme, ce qui a pour effet de relier le point P1 à la terre et le condensateur C1 se décharge à travers les résistances R2 et R3 et la diode D1. La tension au point I1 tombe à un niveau bas B. De manière identique, le point I2 du second détecteur de courant occupe un niveau H ou B selon que le contact CR2 de la seconde ampoule Reed est ouvert ou fermé.

On décrira maintenant les détecteurs de tension DT.

La borne S1 du commutateur CM est reliée à l'une des bornes de l'enroulement primaire d'un transformateur TR1 dont l'autre borne est reliée au neutre N du secteur.

Le secondaire du transformateur TR1 est relié à un redresseur constitué d'un pont de diodes PD1 et d'un condensateur de lissage C2. Le détecteur de tension est complété par un régulateur de tension RT1, constitué d'un circuit de référence 78L05. A la sortie du régulateur de tension RT1, la tension U1 peut prendre soit un niveau haut H, si le primaire du transformateur TR1 est alimenté ou un niveau bas B si ce primaire n'est pas alimenté.

Un second détecteur de tension identique, comprenant un transformateur TR2, est relié à l'autre borne S2 du commutateur CM. Les éléments correspondants de ce second détecteur de tension ont été désignés par les mêmes références que dans le premier détecteur de tension avec le signe '. A la sortie du régulateur de tension RT'1, on obtient une tension U2 ayant soit un niveau haut H, soit un niveau bas B.

Les détecteurs de tension délivrent en outre la tension continue Vcc à travers deux diodes opposées D2 et D3.

Les sorties des détecteurs de courant et de tension sont appliquées à quatre entrées E1, E2, E3 et E4 d'une logique de traitement LT constituée de huit portes logiques NON et onze portes logiques ET reliées selon le logigramme représenté. Cette unité logique de traitement LT présente cinq sorties SS1, SS2, SFC1, SFC2 et STH. La sortie SS1 indique s'il y a une tension sur la borne S1 du commutateur CM. La sortie SS2 indique s'il y a une tension sur le borne S2. La sortie SFC1 indique si l'interrupteur FC1 est ouvert ou fermé. La sortie SFC2 indique si l'interrupteur FC2 est ouvert ou fermé. La sortie STH indique si l'interrupteur thermique TH est ouvert ou fermé. La table de vérité correspondant au logigramme représenté est la suivante:

| SORTIES | Niveau U1 | Niveau U2 | Niveau I1 | Niveau I2 |
|---|---|---|---|---|
| SS1 rotation sens 1 | H | H | H | B |
| SS2 rotation sens 2 | H | H | B | H |
| STH interrupteur thermique TH ouvert | H | H | B | B |
| SFCI interrupteur d'arrêt FC1 ouvert | H | B | B | B |
| SFC2 interrupteur d'arrêt FC2 ouvert | B | H | B | B |

Chacune des sorties de la logique de traitement LT commande la base d'un transistor T1, respectivement T1 à T5, fonctionnant en interrupteur pour l'alimentation d'un voyant lumineux L1, respectivement L2 à L5.

## Revendications

1. Dispositif indicateur de l'état d'un moteur asynchrone monophasé à condensateur de déphasage comportant un interrupteur d'arrêt automatique (FC1, FC2) sur chaque conducteur de phase et un interrupteur thermique (TH) sur le conducteur de retour et dont le sens de rotation peut être inversé au moyen d'un commutateur (CM) permettant d'appliquer la tension d'alimentation sur l'une ou l'autre des bornes du condensateur de déphasage (C), de telle sorte que l'un ou l'autre des enroulements (W1, W2) du moteur travaille en phase principale, caractérisé en ce qu'il comprend deux détecteurs de courant (DC) détectant respectivement la présence de courant dans chacun des conducteurs de phase et présentant chacun une sortie (I1, I2) susceptible de prendre deux états distincts (H, B), deux détecteurs de tension (DT) détectant respectivement la présence d'une tension sur chacune des bornes (S1, S2) du commutateur reliées aux conducteurs de phase et présentant chacun une sortie (U1, U2) susceptible de prendre deux états distincts (H, B), et une logique de traitement (LT) aux entrées de laquelle sont appliqués les états des détecteurs de courant et de tension, cette logique de traitement étant agencée de manière à analyser les différentes combinaisons des états logiques aux entrées et à délivrer, sur cinq sorties (SS1, SS2, SFC1, SFC2, STH), des signaux représentatifs de l'état des interrupteurs d'arrêt automatique, de l'interrupteur thermique et du sens de rotation du moteur.

2. Dispositif selon la revendication 1, caractérisé en ce que les détecteurs de courant (DC) sont constitués, chacun, d'une ampoule Reed (RE1, RE2) autour de laquelle sont enroulées quelques spires du conducteur de phase dont le courant doit être détecté et d'un circuit associé comprenant une résistance (R1) reliée à une source de courant continu (Vcc) et en série avec le contact de Reed (CR1, CR2), de telle sorte qu'elle est reliée à la terre lors de la fermeture du contact Reed et que les détecteurs de tension (DT) sont constitués chacun d'un transformateur (TR1, TR2) et d'un redresseur fournissant également la tension continue (Vcc) d'alimentation des détecteurs de courant.

3. Dispositif selon la revendication 2, caractérisé en ce que le circuit associé à chacune des ampoules Reed des détecteurs de courant est constitué, en plus de ladite résistance, d'une diode (D1), d'une deuxième résistance (R2) et d'un condensateur (C1) en parallèle au contact Reed (CR1) et d'une troisième résistance (R3) branchée en parallèle à la diode et à la deuxième résistance.

4. Dispositif selon la revendication 2 ou 3, caractérisé en ce que chaque détecteur de tension comprend un régulateur de tension continue (RT).

5. Dispositif selon l'une des revendications 1 à 4, caractérisé en ce qu'il comprend des moyens d'affichage (L1 à L5) de l'état des sorties de la logique de traitement.

6. Dispositif selon l'une des revendications 1 à 4, caractérisé en ce que les détecteurs de courant et de tension et la logique de traitement sont montés dans un boîtier commun.
